Europäisches Patentamt

European Patent Office

Office européen des brevets

(11) Veröffentlichungsnummer: **0 248 244**
**B1**

## EUROPÄISCHE PATENTSCHRIFT

(45) Veröffentlichungstag der Patentschrift:
**10.01.90**

(21) Anmeldenummer: **87107039.7**

(22) Anmeldetag: **15.05.87**

(51) Int. Cl.⁴: **H 01 J 37/34, C 23 C 14/34**

(54) Magnetron-Zerstäubungskatode für Vakuum-Beschichtungsanlagen.

(30) Priorität: **06.06.86 DE 3619194**

(43) Veröffentlichungstag der Anmeldung:
**09.12.87 Patentblatt 87/50**

(45) Bekanntmachung des Hinweises auf die Patenterteilung:
**10.01.90 Patentblatt 90/2**

(84) Benannte Vertragsstaaten:
**CH DE FR GB LI NL**

(56) Entgegenhaltungen:
**EP-A- 0 144 838**
**DE-A- 3 506 227**
**US-A- 4 444 643**

(73) Patentinhaber: **LEYBOLD AKTIENGESELLSCHAFT,
Wilhelm-Rohn-Strasse 25, D-6450 Hanau am Main 1 (DE)**

(72) Erfinder: **Ferenbach, Dagmar, Dipl.-Ing.,
Gnaitastrasse 15, D-5100 Aachen (DE)**
Erfinder: **Steiniger, Gerhard, Dipl.-Phys.,
Bettinastrasse 66, D-6050 Offenbach am Main (DE)**
Erfinder: **Müller, Jürgen, Dr. Dipl.-Phys.,
Goldgrabenstrasse 8, D-6000 Frankfurt am Main (DE)**

(74) Vertreter: **Zapfe, Hans, Dipl.-Ing. et al, Am Eichwald 7,
D-6056 Heusenstamm 2 Rembrücken (DE)**

## Beschreibung

Die Erfindung betrifft eine Magnetron-Zerstäubungskatode für Vakuum-Beschichtungsanlagen mit einer kreisförmigen Targetplatte aus dem zu zerstäubenden Material und mit mindestens einem hinter der Targetplatte angeordneten Magnetsystem, das aus jeweils zwei ineinanderliegenden in sich geschlossenen Reihen von Permanentmagneten besteht, wobei die Magnete einer jeden Reihe die gleiche Pollage, die Magnete beider Reihen aber zueinander eine entgegengesetzte Pollage aufweisen, derart, daß über der Targetplatte mindestens ein in sich geschlossener Tunnel aus von der einen Magnetreihe ausgehenden und zur anderen Magnetreihe zurückkehrenden magnetischen Feldlinien gebildet wird, und mit einer Antriebseinrichtung für die kontinuierliche Drehung des Magnetsystems oder der Magnetsysteme um die Mittenachse der Targetplatte.

Magnetron-Zerstäubungskatoden zeichnen sich durch eine um den Faktor 10 bis 30 höhere Zerstäubungsrate gegenüber Zerstäubungssystemen ohne Magnetfeldunterstützung aus. Dieser Vorteil wird jedoch mit dem Nachteil einer äußerst ungleichförmigen Zerstäubung der Targetplatte erkauft, denn die bei Magnetrons durch den magnetischen Tunnel erzwungene Einschnürung des Plasmas äußert sich in einer entsprechenden räumlichen Begrenzung des Zerstäubungseffekts. Durch Ausbildung eines tiefen Erosionsgrabens, dessen tiefste Stelle unter den Kulminationspunkten der magnetischen Feldlinien liegt, muß der Zerstäubungsvorgang beendet werden, nachdem nur etwa 25 bis 30% des Targetmaterials zerstäubt sind. Bei stationären Beschichtungssystemen, d.h. bei solchen ohne Relativbewegung zwischen Katode und den Substraten hat dies sehr ungleichmäßige Schichtdickenverteilungen zur Folge. Im Prinzip würde der Erosionsgraben quasi fotografisch auf den Substraten abgebildet.

Diese Problematik sowie eine Reihe von Lösungsversuchen werden in der DE-OS-2 707 144 angesprochen. Zu den Lösungsversuchen gehört auch eine Magnetron-Zerstäubungskatode der eingangs angegebenen Gattung, bei der jeweils ein einziges in sich geschlossenes Magnetsystem in exzentrischer Lage hinter einer kreisförmigen Targetplatte rotiert (Figuren 22 bis 25). Abgesehen davon, daß hierbei nur ein winziger Teil der Targetoberfläche gleichzeitig der Zerstäubung ausgesetzt wird (womit ein Teil des Magnetron-Effekts wieder zunichte gemacht wird) ist die Zerstäubungsrate auf der Targetoberfläche auch sehr ungleichmäßig, weil einmal die Verweilzeiten unter dem rotierenden magnetischen Tunnel ungleichmäßig sind und weil zum andern das Produkt aus der Intensität des Plasmas, der sogenannten Plasmadichte, und der Verweilzeit in radialer Richtung unterschiedlich sind. Eine ungleichförmige Zerstäubungsrate führt aber nicht nur zu einer ungleichförmigen Abtragung des Targermaterials, sondern auch zu einer ungleichförmigen Niederschlagsrate auf den der Targetoberfläche gegenüberliegenden und zu beschichtenden Substraten.

Der Erfindung liegt daher die Aufgabe zugrunde, eine Magnetron-Zerstäubungskatode der eingangs angegebenen Gattung dahingehend zu verbessern, daß die Schichtdickenverteilung auf den zu beschichtenden Substraten vergleichmäßigt wird.

Die Lösung der gestellten Aufgabe erfolgt bei der eingangs angegebenen Magnetron-Zerstäubungskatode erfindungsgemäß dadurch, daß

a) im Randbereich der Targetplatte ein erstes Magnetsystem für die Erzeugung eines ersten, zur Drehachse im wesentlichen konzentrischen magnetischen Tunnels angeordnet ist, und daß

b) innerhalb der inneren Reihe des ersten Magnetsystems ein bezüglich der Drehachse exzentrisch versetztes zweites Magnetsystem angeordnet ist, das einen zweiten magnetischen Tunnel erzeugt, der sich nur über einen Sektor der Targetplatte erstreckt, derart, daß bei einer gemeinsamen Drehung beider Magnetsysteme um die Drehachse die Flächenelemente der Targetplatte dem Produkt aus Verweilzeit und Intensität des Plasmas dergestalt ausgesetzt sind, daß die Targetplatte im mittleren Bereich gleichmäßig und am Rande stärker als im mittleren Bereich abgetragen wird, so daß ein gegenüber der Targetplatte angebrachtes Substratfeld gleichförmig beschichtet wird.

Unter «Substratfeld» wird entweder die von einer kreisförmigen Umrißlinie eines einzelnen Substrats oder einer Anzahl kleinerer Substrate umschriebene Fläche verstanden.

Durch das Merkmal a) wird die ansonsten im Randbereich des Substratfeldes zu beobachtende Verminderung der Niederschlagsrate kompensiert. Hierbei ist nämlich zu berücksichtigen, daß Flächenelemente auf den Substraten im Randbereich des Substratfeldes ohne besondere Maßnahmen weniger Schichtmaterial erhalten, weil die zerstäubten Partikel sich in verschiedenen, von der Normalen zur Targetoberfläche abweichenden Richtungen bewegen und ein im Randbereich des Substratfeldes liegendes Flächenelement des Substrats einfach weniger Targetfläche «sieht» als ein in der Mitte liegendes Substrat.

Durch das Merkmal b) wird erreicht, daß auch der innerhalb des Randbereichs liegende Bereich des Substratfeldes gleichmäßig beschichtet wird. Eine ähnliche Vorrichtung ist aus US-A-4 444 643 bekannt. Bei der erfindungsgemäßen Anordnung hat man es jedoch durch die Gestaltung der Ausdehnung des Sektors und des Verlaufs des zweiten magnetischen Tunnels in diesem Sektor in der Hand, eine außerordentlich gleichmäßige Beschichtung über das gesamte Substratfeld herbeizuführen.

Eine Optimierung des Systems kann durch Verschieben der magnetischen Tunnel auf der Jochplatte der Magnete erfolgen, wenn der Fachmann Abweichungen von der idealen Schichtdickenverteilung beobachten sollte.

Es hat sich in praktischen Versuchen herausgestellt, daß durch die Verknüpfung der Merkmale a) und b) auf den Substraten bis in den Randbereich des Substratfeldes eine sehr gleichmäßige Schichtdickenverteilung erzielt werden konnte.

Es ist dabei nicht erforderlich, daß der erste magnetische Tunnel gemäß Merkmal a) konzentrisch zur Drehachse verläuft, so daß das Plasma ohne Querverschiebung «auf der Stelle» rotiert, sondern es ist zur Regulierung der Verteilung der Niederschlagsrate mit besonderem Vorteil möglich, den ersten magnetischen Tunnel von der Kreisform abweichend zu gestalten, beispielsweise durch eine Abflachung oder sogar Einbuchtung an einer oder mehreren Stellen, oder den ersten magnetischen Tunnel leicht exzentrisch rotieren zu lassen. Es ist lediglich erforderlich, daß der erste magnetische Tunnel im wesentlichen konzentrisch zur Drehachse verläuft.

Es ist gemäß einer Weiterbildung der Erfindung besonders vorteilhaft, wenn das zweite Magnetsystem eine äußere Reihe von Permanentmagneten aufweist, deren Magnete dieselbe Pollage wie die der Magnete der inneren Reihe des ersten Magnetsystems aufweisen, welche äußere Reihe sich über einen Dreiviertelkreis erstreckt, dessen vierter Quadrant durch Permanentmagnete der inneren Reihe von Permanentmagneten des ersten Magnetsystems ergänzt wird, und daß die innere Reihe von Permanentmagneten des zweiten Magnetsystems mit im wesentlichen gleichen Abständen zu den Permanentmagneten entgegengesetzter Pollage verläuft.

Auf diese Weise können die Plasmaentladungen beider Magnetsysteme in unmittelbare Nachbarschaft zueinander gebracht werden, und es wird fernerhin ein Teil der teuren Permanentmagnete eingespart, worauf in der Detailbeschreibung noch näher hingewiesen wird.

Es ist schließlich gemäß einer wiederum weiteren Ausgestaltung der Erfindung besonders vorteilhaft, wenn sämtliche Permanentmagnete auf einer drehbaren, zur Targetplatte koaxialen ferromagnetischen Jochplatte angeordnet sind, die auf einer Hohlwelle befestigt ist, und wenn die beiden Magnetreihen des zweiten, inneren Magnetsystems beiderseits der Öffnung der Hohlwelle verlaufen.

Zwei Ausführungsbeispiele des Erfindungsgegenstandes werden nachstehend anhand der Figuren 1 bis 3 näher erläutert.

Es zeigen:

Figur 1 eine Draufsicht auf die Magnetsysteme einer Magnetron-Zerstäubungskatode nach der Erfindung,

Figur 2 einen Axialschnitt durch eine Magnetron-Zerstäubungskatode mit den Magnetsystemen nach Figur 1 und

Figur 3 eine Draufsicht auf eine Variante des gegenstandes nach Figur 1, bei der der äußere magnetische Tunnel auf einem Teilumfang der Targetplatte geringfügig radial einwärts zurückgesetzt ist.

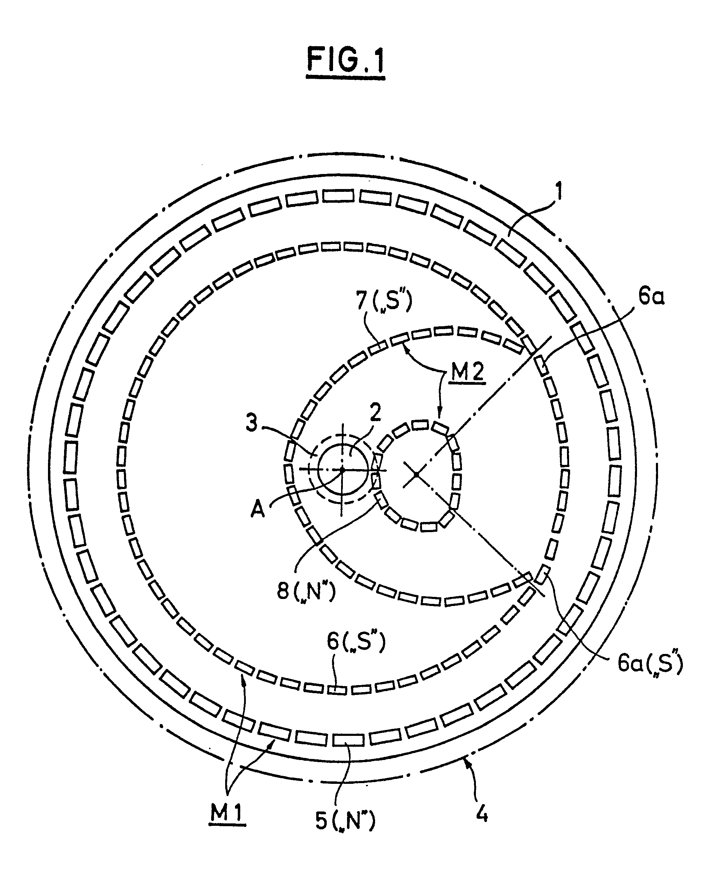

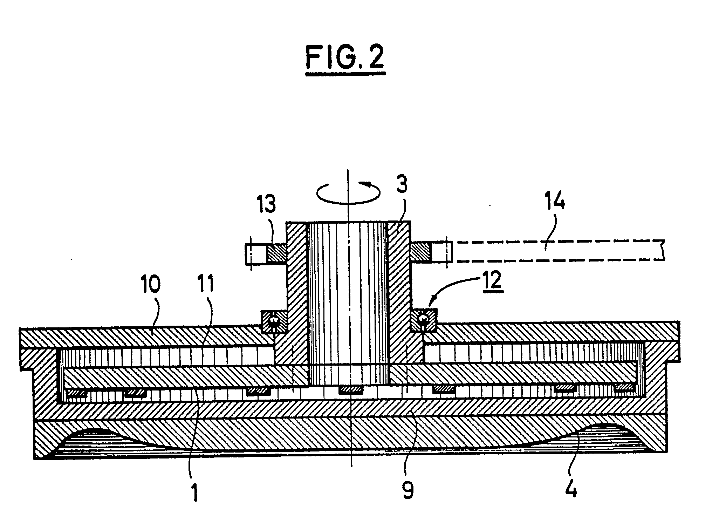

In Figur 1 ist eine kreisringförmige Jochplatte 1 dargestellt, die in ihrem Zentrum eine Öffnung 2 aufweist, die mit einer Hohlwelle 3 kommuniziert, an der die Jochplatte 1 befestigt ist. Mittels dieser Hohlwelle 3 ist die Jochplatte 1 um eine gemeinsame konzentrische Achse A drehbar. Diese Jochplatte ist nahezu so groß wie die in Figur 2 dargestellte Targetplatte, so daß die für die Jochplatte geltenden geometrischen Verhältnisse sehr weitgehend auch für die Targetplatte gelten. Der Rand der Targetplatte 4 ist in Figur 1 strichpunktiert dargestellt.

Es ist zu erkennen, daß im Randbereich der Targetplatte 4 ein erstes Magnetsystem M1 angeordnet ist, das aus zwei konzentrisch ineinanderliegenden, in sich geschlossenen Reihen von Permanentmagneten 5 und 6 besteht, wobei die Magnete 5 der äußeren Reihe untereinander die gleiche Pollage aufweisen (z.B. «N»), gegenüber der inneren Magnetreihe 6 die entgegengesetzte Pollage aufweisen. Die Magnete 6 der inneren Reihe haben beispielsweise die Pollage «S». Dadurch wird in an sich bekannter Weise über der Targetplatte 4 ein in sich geschlossener Tunnel aus von der Magnetreihe 5 ausgehenden und zur Magnetreihe 6 zurückkehrenden magnetischen Feldlinien gebildet. Das erste Magnetsystem M1 erzeugt im Fall von Figur 1 einen zur Drehachse A konzentrischen magnetischen Tunnel.

Innerhalb der inneren Reihe 6 des ersten Magnetsystems M1 befindet sich ein exzentrisch versetztes zweites Magnetsystem M2, das gleichfalls aus zwei ineinanderliegenden in sich geschlossenen Reihen von Permanentmagneten 7 und 8 besteht, wobei die Magnete der äußeren Magnete 7 untereinander die gleiche Pollage (z.B. «S»), gegenüber der inneren Reihe von Magneten 8, jedoch die entgegengesetzte Pollage einnimmt. Die innere Reihe von Magneten 8 besitzt in sich wiederum die gleiche Pollage (z.B. «N»). Dadurch wird erreicht, daß über der Targetplatte 4 ein zweiter, in sich geschlossener Tunnel aus magnetischen Feldlinien aufgebaut wird, die von der einen Magnetreihe (7) ausgehen und zur anderen Magnetreihe (8) zurückkehren. Es ist weiterhin zu erkennen, daß das Magnetsystem M2 bzw. der dadurch gebildete magnetische Tunnel sich über einen Sektor der Targetplatte erstreckt, und zwar etwa über einen Quadranten der Targetplatte 4.

Aus Figur 1 geht weiterhin hervor, daß die äußere Reihe von Permanentmagneten 7 des zweiten Magnetsystems M2 sich über einen Dreiviertelkreis erstreckt, also einen vierten Quadranten freiläßt, der durch die beiden strichpunktierten Linien angedeutet ist. Innerhalb des vierten Quadranten wird die Reihe der Permanentmagnete 7 durch Permanentmagnete 6a der inneren Reihe von Permanentmagneten 6 des ersten Magnetsystems M1 ergänzt, so daß in diesem Quadranten die unmittelbar benachbarte Parallelanordnung von Magneten gleicher Pollage vermieden und diese Magnete eingespart werden.

Dabei verläuft die innere Reihe von Permanentmagneten 8 des zweiten Magnetsystems M2 mit im wesentlichen den gleichen Abständen zu den Permanentmagneten 7 entgegengesetzter Pollage.

Bei einer Drehung des Magnetsystems gemäß Figur 1 relativ zur Targetplatte 4 stellt sich der Effekt ein, daß jedes Flächenelement der Targetplatte 4 etwa dem gleichen Produkt aus Verweilzeit und Intensität des Plasmas dergestalt ausgesetzt ist, daß der mittlere Bereich gleichmäßig und am Rande stärker abgetragen wird, so daß ein gegenüber der Targetplatte angebrachtes Substratfeld gleichmäßig beschichtet wird.

In Figur 2 wird gezeigt, daß die Targetplatte 4, die bereits einen deutlichen Materialverbrauch erkennen läßt, auf einem Katodengrundkörper 9 befestigt ist (beispielsweise durch Löten oder Bonden), der aus einer kreisscheibenförmigen Kupferwanne besteht. Der Katodengrundkörper 9 ist an einer Tragplatte 10 befestigt, die ihrerseits über nicht gezeigte Isolatoren mit der gleichfalls nicht gezeigten Vakuumkammer verbunden ist. Zwischen dem Katodengrundkörper 9 und der Tragplatte 10 wird ein flacher zylindrischer Hohlraum 11 gebildet, in dem die Jochplatte 1 mit den hier nicht näher bezeichneten Permanentmagnete (schwarze Flächen) konzentrisch und drehbar angeordnet ist. Zum Zwecke einer Drehung der Jochplatte 1 ist sie an der Hohlwelle 3 befestigt, die sich über eine Drehlagerung 12 an der Tragplatte 10 abstützt. Die Hohlwelle 3 dient zur Einleitung und Ableitung von Kühlwasser, wobei die Kühlwasserführungen der Einfachheit halber fortgelassen sind. Die Hohlwelle 3 wird über eine Zahnscheibe 13 und einen Zahnriemen 14 in Drehung versetzt.

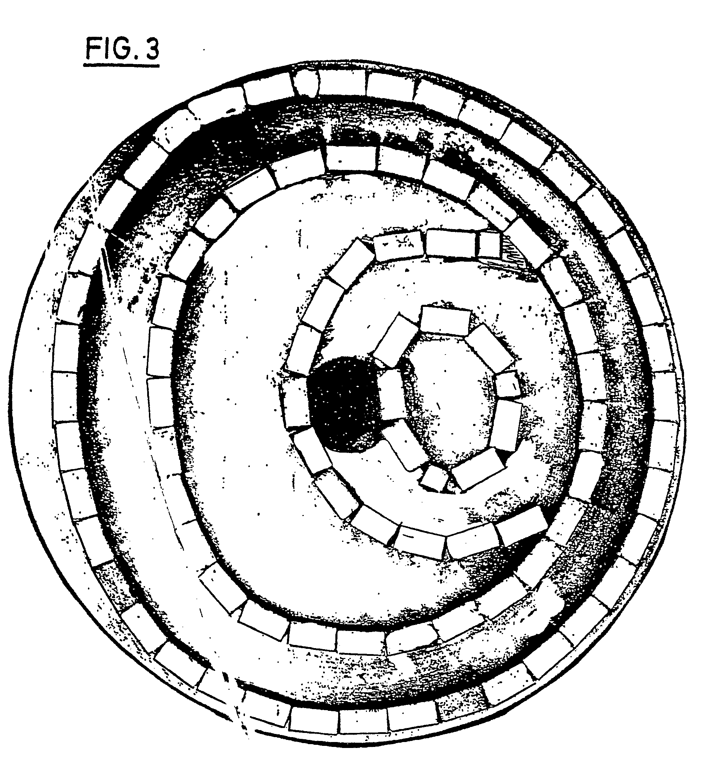

Figur 3 zeigt die maßstäbliche Anordnung der einzelnen Permanentmagnete in weitgehender Übereinstimmung mit Figur 1, so daß auf eine Bezifferung verzichtet wurde. Es ist jedoch zu erkennen, daß die beiden Reihen von Permanentmagneten des ersten bzw. äußeren Magnetsystems M1 auf einem Teilumfang der Jochplatte 1 etwas radial einwärts versetzt angeordnet sind, so daß auch der äußere magnetische Tunnel bei seiner Drehung relativ zur Targetplatte eine Art Wobbelbewegung ausführt. Dieser Wobbelbewegung des magnetischen Tunnels folgt naturgemäß das von dem magnetischen Tunnel eingeschlossene Plasma. Ähnliche Überlegungen gelten auch für das durch das zweite, innere Magnetsystem M2 eingeschlossene Plasma, allerdings in sehr verstärktem Maße. Die beiden Plasmaräume und ihre rotierende Bewegung ergänzen sich in vorteilhafter Weise und bewirken eine gleichförmige bzw. flächige Beschichtung des Substrats bzw. der Substrate innerhalb des Substratfeldes.

## Patentansprüche

1. Magnetron-Zerstäubungskatode für Vakuum-Beschichtungsanlagen mit einer kreisförmigen Targetplatte aus dem zu zerstäubenden Material und mit mindestens einem hinter der Targetplatte angeordneten Magnetsystem, das aus jeweils zwei ineinanderliegenden in sich geschlossenen Reihen von Permanentmagneten besteht, wobei die Magnete einer jeden Reihe die gleiche Pollage, die Magnete beider Reihen aber zueinander eine entgegengesetzte Pollage aufweisen, derart, daß über der Targetplatte mindestens ein in sich geschlossener Tunnel aus von der einen Magnetreihe ausgehenden und zur anderen Magnetreihe zurückkehrenden magnetischen Feldlinien gebildet wird, und mit einer Antriebseinrichtung für die kontinuierliche Drehung des Magnetsystems oder der Magnetsysteme um die Mittenachse der Targetplatte, dadurch gekennzeichnet, daß

a) im Randbereich der Targetplatte (4) ein erstes Magnetsystem (M1) für die Erzeugung eines ersten, zur Drehachse (A) im wesentlichen konzentrischen magnetischen Tunnels angeodnet ist, und daß

b) innerhalb der inneren Reihe (b) des ersten Magnetsystems (M1) ein bezüglich der Drehachse (A) exzentrisch versetztes zweites Magnetsystem (M2) angeordnet ist, das einen zweiten magnetischen Tünnel erzeugt, der sich nur über einen Sektor der Targetplatte (4) erstreckt,

derart, daß bei einer gemeinsamen Drehung beider Magnetsysteme um die Drehachse (A) die Flächenelemente der Targetplatte dem Produkt aus Verweilzeit und Intensität dergestalt ausgesetzt sind, daß die Targetplatte im mittleren Bereich gleichmäßig und am Rande stärker als im mittleren Bereich abgetragen wird, so daß ein gegenüber der Targetplatte angebrachtes Substratfeld gleichförmig beschichtet wird.

2. Magnetron-zerstäubungskatode nach Anspruch 1, dadurch gekennzeichnet, daß das zweite Magnetsystem (M2) eine äußere Reihe von Permanentmagneten (7) aufweist, deren Magnete dieselbe Pollage wie die der Magnete der inneren Reihe (b) des ersten Magnetsystems (M1) aufweisen, welche äußere Reihe sich über einen Dreiviertelkreis erstreckt, dessen vierter Quadrant durch Permanentmagnete (6a) der inneren Reihe von Permanentmagneten (6) des ersten Magnetsystems (M1) ergänzt wird, und daß die innere reihe von Permanentmagneten (8) des zweiten Magnetsystems (M2) mit im wesentlichen gleichen Abständen zu den Permanentmagneten (7) entgegengesetzter Pollage verläuft.

3. Magnetron-Zerstäubungskatode nach Anspruch 2, dadurch gekennzeichnet, daß sämtliche Permanentmagnete (5, 6, 6a, 7, 8) auf einer drehbaren, zur Targetplatte (4) koaxialen ferromagnetischen Jochplatte (1) angeordnet sind, die auf einer Hohlwelle (3) befestigt ist, und daß die beiden Magnetreihen des zweiten, inneren Magnetsystems (M2) beiderseits der Öffnung (2) der Hohlwelle verlaufen.

## Claims

1. Magnetron sputtering cathode for vacuum coating apparatus having a circular target plate made of the material to be sputtered and having, disposed behind the target plate, at least one magnet system comprising in each case two self-contained rows of permanent magnets, one lying inside the other, the magnets in any one row having the same pole position while in each pair of rows, the magnets of one row have the opposite pole position to that of the other row so that there is formed above the target plate at least one self-contained tunnel of flux lines originating from one row of magnets and returning to the other row of magnets, and having a drive device for continuous rotation of the magnet system or magnet systems about the central axis of the target plate, characterised in that

a) a first magnet system (M1) for producing a first magnetic tunnel substantially concentric to the axis of rotation (A) is disposed in the edge region of the target plate (4), and

b) a second magnet system (M2) eccentrically offset relative to the axis of rotation (A) is disposed inside the inner row (6) of the first magnet system (M1) and produces a second magnetic tunnel which extends only over a sector of the target plate (4), so that, upon joint rotation of both magnet systems about the axis of rotation (A), the surface elements of the target plate are exposed to the product of dwell time and intensity in such a manner that the target plate is worn uniformly in the central region and to a greater extent at the edge than in the central region, with the result that a substrate field mounted opposite the target plate is uniformly coated.

2. Magnetron sputtering cathode according to claim 1, characterised in that the second magnet system (M2) has an outer row of permanent magnets (7) whose magnets have the same pole position as that of the magnets of the inner row (6) of the first magnet system (M1), said outer row extending over three quarters of a circle whose fourth quadrant is made up of permanent magnets (6a) of the inner row of permanent magnets (6) of the first magnet system (M1), and the inner row of permanent magnets (8) of the second magnet system (M2) extends at substantially the same distance from the permanent magnets (7) of the opposite pole position.

3. Magnetron sputtering cathode according to claim 2, characterised in that all the permanent magnets (5, 6, 6a, 7, 8) are disposed on a rotatable ferromagnetic yoke plate (1) which is coaxial to the target plate (4) and is fastened on a hollow shaft (3), and the two rows of magnets of the second inner magnet system (M2) extend on either side of the opening (2) of the hollow shaft.

**Revendications**

1. Cathode de pulvérisation du type magnéton, pour installations de revêtement sous vide, comportant: une plaque-cible circulaire faite de la matière à pulvériser; et au moins un système magnétique agencé derrière la plaque-cible et constitué par deux rangées fermées d'aimants permanents dont l'une est située à l'intérieur de l'autre, les aimants de chaque rangée présentant la même position polaire, tandis que les aimants des deux rangées ont une position polaire opposée de manière à former sur la plaque-cible au moins un tunnel fermé constitué par des lignes de champ magnétique partant d'une première rangée d'aimants et revenant à l'autre rangée d'aimants; et un dispositif d'entraînement pour faire tourner de manière continue le ou les systèmes magnétiques autour de l'axe central de la plaque-cible, caractérisée par le fait que

a) un premier système magnétique (M1) pour engendrer un premier tunnel magnétique sensiblement concentrique à l'axe de rotation (A) est agencé dans la région du bord de la plaque-cible (4), et que

b) un deuxième système magnétique (M2) excentré par rapport à l'axe de rotation (A) est agencé à l'intérieur de la rangée intérieure (6) du premier système magnétique (M1) et engendre un deuxième tunnel magnétique qui ne s'étend que sur un secteur de la plaque-cible (4),

de sorte que, lors d'une rotation commune des deux systèmes magnétiques autour de l'axe de rotation (A), les éléments de surface de la plaque-cible sont exposés au produit temps de séjour par intensité de manière telle que la plaque-cible soit érodée uniformément dans la région médiane et plus fortement en son bord que dans la région médiane, de manière qu'un champ de substrat agencé en vis-à-vis de la plaque-cible soit revêtu uniformément.

2. Cathode de pulvérisation du type magnétron selon revendication 1, caractérisée par le fait que le deuxième système magnétique (M2) présente une rangée extérieure d'aimants permanents (7) dont les aimants présentent la même position polaire que les aimants de la rangée intérieure (6) du premier système magnétique (M1), cette rangée extérieure s'étendant sur les trois quarts d'un cercle dont le quatrième quadrant est complété par des aimants permanents (6a) de la rangée intérieure d'aimants permanents (6) du premier système magnétique (M1), et par le fait que la rangée intérieure d'aimants permanents (8) du deuxième système magnétique (M2) suit un tracé à distance sensiblement égale des aimants permanents (7) de position polaire opposée.

3. Cathode de pulvérisation du type magnétron selon revendication 2, caractérisée par le fait que tous les aimants permanents (5, 6, 6a, 7, 8) sont agencés sur une plaque-culasse ferromagnétique tournante (1), coaxiale à la plaque-cible (4) et fixée à un arbre creux (3), et par le fait que les deux rangées d'aimants du deuxième système magnétique, système intérieur (M2), suivent des tracés des deux côtés de l'ouverture (2) de l'arbre creux.

# FIG.1

# FIG.2

## FIG. 3